# EUROPÄISCHE PATENTANMELDUNG

(11) **EP 3 629 688 A1**
(43) Veröffentlichungstag der Anmeldung: **01.04.2020**
(21) Anmeldenummer: 18197064.1
(22) Anmeldetag: 27.09.2018
(51) Int. Cl.: H05K 7/20

(54) **STROMRICHTER MIT EINEM SEPARATEN INNENRAUM**

(71) Anmelder: Siemens Aktiengesellschaft, 80333 München (DE)
(72) Erfinder: Frana, Christian, 90556 Cadolzburg (DE); Lodes, Stefan, 91278 Pottenstein (DE); Nieberlein, Klaus, 90471 Nürnberg (DE)

(57) **Zusammenfassung**

Die Erfindung betrifft einen Stromrichter (1), welcher ein Stromrichtergehäuse (2) mit einem ersten Innenraum (3) und einem zweiten Innenraum (4) umfasst, wobei der erste Innenraum (3) zum zweiten Innenraum (4) separat angeordnet ist, wobei ein Teil des ersten Innenraumes (3) in den zweiten Innenraum (4) ragt und einen Wärmetauscherkanal (5) bildet, wobei der Stromrichter (1) derart betreibbar ist, dass sich innerhalb des ersten Innenraumes (3) ein gasförmiger Wärmestromkreislauf (6) ausbildet, welcher durch eine erste Einlassöffnung (15) des Wärmetauscherkanals (5) einströmt und durch eine erste Auslassöffnung (16) des Wärmetauscherkanals (5) ausströmt, wobei der zweite Innenraum (4) einen Kühlkanal (7) bildet, wobei der Stromrichter (1) derart betreibbar ist, dass sich ein durch den Kühlkanal (7) strömender gasförmiger Kühlstrom (8) ausbildet, welcher den Wärmetauscherkanal (5) umströmt, und wobei der Kühlkanal (7) in einem überlappenden Bereich mit dem Wärmetauscherkanal (5) derart angeordnet ist, dass eine erste Strömungsrichtung (9) des gasförmigen Wärmestromkreislaufs (6) in Bezug zu einer zweiten Strömungsrichtung (10) des gasförmigen Kühlstroms (8) im Wesentlichen senkrecht oder parallel verläuft.

## Beschreibung

Die Erfindung betrifft einen Stromrichter welcher ein Stromrichtergehäuse mit einem ersten Innenraum und einem zweiten Innenraum umfasst, wobei der erste Innenraum zum zweiten Innenraum separat angeordnet ist und eine im Betrieb des Stromrichters im ersten Innenraum erzeugbare erste Verlustwärme zumindest teilweise in den zweiten Innenraum abführbar ist und der erste Innenraum dadurch zumindest teilweise entwärmt wird.

In der Antriebstechnik sind elektrische bzw. elektronische Bauelemente von z.B. Stromrichtern im Betrieb oftmals aggressiven Umwelteinflüssen ausgesetzt, wie z.B. Spritzwasser oder Staub, was sich bei Vernachlässigung von Schutzmaßnahmen negativ auf die Verfügbarkeit bzw. die Lebensdauer der Bauelemente auswirken kann.

Als meist einfachste Maßnahme zur Verhinderung von Schäden, welche für Stromrichter und ihre insbesondere elektronischen Bauelemente, wie Steuerung- und Reglungseinheiten, aus den genannten Umwelteinflüssen entstehen, können diese elektronischen Bauelemente oder zu elektronischen Baugruppen zusammengefasste elektronische Bauelemente von einem Gehäuse umfasst werden.

Der je nach Anwendungsart und Anwendungsort des Stromrichters notwendige Abschottungsgrad gegenüber den negativen Umwelteinflüssen ist z.B. mit den IP-Schutzarten in der Norm DIN EN 60529 festgelegt. Diese Norm definiert die Schutzarten als Schutz gegen direktes Berühren der elektronischen Bauelemente aber auch gegen Eindringen von Feststoffen und Flüssigkeiten in den Stromrichter.

Ein Problem dieser Abschottung von elektronischen Bauelementen bzw. Baugruppen ist jedoch, dass im Betrieb des Stromrichters z.B. durch die elektrischen Verluste der elektronischen Bauelemente eine sogenannte Verlustwärme erzeugt wird. Diese Verlustwärme muss von den elektronischen Bauelementen, wie z.B. von Prozessoren, von passiven Bauelementen etc., abgeführt werden, da aufgrund der Wärmeentwicklung der Wirkungsgrad der betroffenen elektronischen Bauelemente sinken kann oder diese eventuell auch zerstört werden können.

In bekannten Lösungen wird die Entwärmung derart abgeschotteter Bereiche in Stromrichtern z.B. über eine stromrichterinterne Luftumwälzung und/oder über Oberflächenkonvektion durchgeführt. Dies ermöglicht aber nur die Abfuhr einer begrenzten Wärmemenge, insbesondere dann, wenn eine hohe Schutzart für einen Stromrichter einer hohen Leistungsklasse vorgesehen ist.

Alternativ sind Entwärmungssysteme für Stromrichter z.B. höherer Schutzarten und höherer Leistungsklassen bekannt, bei denen eine Abfuhr der Verlustwärme mittels Luftumwälzung über technisch aufwendige Filter durchgeführt wird. Diese Entwärmungssysteme mit Filtern sind teuer, sehr wartungsintensiv und benötigen oft Lüfter mit hohem Energiebedarf, um den hohen Luftwiderstand zu überwinden und den erforderlichen Luftdurchsatz zu gewährleisten.

Der Erfindung liegt daher die Aufgabe zugrunde, einen Stromrichter mit einem separaten Innenraum für eine hohe Schutzart bereitzustellen, um die Verlustwärme erzeugenden elektronischen Bauelemente des abgeschotteten Innenraums aufwandsärmer gegenüber dem Stand der Technik bei zumindest gleichbleibender Effizienz der Wärmeabfuhr zu entwärmen.

Die Aufgabe wird durch einen Stromrichter mit den in Anspruch 1 angegebenen Merkmalen gelöst.

Für die Lösung der Aufgabe wird ein Stromrichter vorgeschlagen, welcher ein Stromrichtergehäuse mit einem ersten Innenraum und einem zweiten Innenraum umfasst, wobei der erste Innenraum zum zweiten Innenraum separat angeordnet ist, wobei ein Teil des ersten Innenraumes in den zweiten Innenraum ragt und einen Wärmetauscherkanal bildet, wobei der Stromrichter derart betreibbar ist, dass sich innerhalb des ersten Innenraumes ein gasförmiger Wärmestromkreislauf ausbildet, welcher durch eine erste Einlassöffnung des Wärmetauscherkanals einströmt und durch eine erste Auslassöffnung des Wärmetauscherkanals ausströmt, wobei der zweite Innenraum einen Kühlkanal bildet, wobei der Stromrichter derart betreibbar ist, dass sich ein durch den Kühlkanal strömender gasförmiger Kühlstrom ausbildet, welcher den Wärmetauscherkanal umströmt, und wobei der Kühlkanal in einem überlappenden Bereich mit dem Wärmetauscherkanal derart angeordnet ist, dass eine erste Strömungsrichtung des gasförmigen Wärmestromkreislaufs in Bezug zu einer zweiten Strömungsrichtung des gasförmigen Kühlstroms im Wesentlichen senkrecht oder parallel verläuft.

Über den Wärmetauscherkanal ist in vorteilhafter Weise ein Wärmetausch zwischen zwei voneinander separierten Innenräumen des Stromrichters durchführbar, wobei der gasförmige Wärmestromkreislauf des ersten Innenraums im Betrieb des Stromrichters seine mitgeführte Wärme über den Wärmetauscherkanal an den gasförmigen Kühlstrom im Kühlkanal des zweiten Innenraums abgeben kann und die so abgegebene Wärme mittels des gasförmigen Kühlstroms in den zweiten Innenraum abgleitet werden kann. Beide Wärmeströme vermischen ihr jeweiliges gasförmiges Medium demnach beim Wärmetausch nicht.

Verläuft die erste Strömungsrichtung des gasförmigen Wärmestromkreislaufs in Bezug zur zweiten Strömungsrichtung des gasförmigen Kühlstroms im Wesentlichen senkrecht, kann der geführte gasförmige Kühlstrom in vorteilhafter Weise gleichzeitig auf einer breiten Front die Wärme des geführten gasförmige Wärmestromkreislauf übernehmen.

Verläuft die erste Strömungsrichtung des gasförmigen Wärmestromkreislaufs in Bezug zur zweiten Strömungsrichtung des gasförmigen Kühlstroms im Wesentlichen parallel, kann der geführte gasförmige Kühlstrom in vorteilhafter Weise über eine längere Wegstrecke die Wärme des geführten gasförmige Wärmestromkreislauf übernehmen.

Beide Arten der Führung des gasförmigen Wärmestromkreislaufs gegenüber dem gasförmigen Kühlstrom haben Vorteile, welche insbesondere durch eine bauliche Auslegung des jeweiligen Wärmetauscherkanals bzgl. dessen thermischen Verhaltens beim Wärmetausch weiter verbessert werden kann.

Vorteilhafte Ausgestaltungsformen des modularen Umrichters sind in den abhängigen Ansprüchen angegeben.

Bei einer ersten vorteilhaften Ausgestaltungsform des Stromrichters bildet der erste Innenraum zumindest im Betrieb des Stromrichters einen im Wesentlichen hermetisch abgeschlossen Raum aus.

Als hermetisch abgeschlossen wird der erste Innenraum dann betrachtet, wenn insbesondere Staub, aufgenommen durch gasförmige Umgebungsmedien, im Allgemeinen Luft, sowie flüssige Medien im Betrieb nicht in den ersten Innenraum eindringen können.

Zumindest ist der erste Innenraum für z.B. eine Einstufung der IP-Schutzart nach DIN EN 60529 von IP5x und höher ausgelegt, um derart hermetisch abgeschlossen zu sein.

Bei einer weiteren vorteilhaften Ausgestaltungsform des Stromrichters ist der Stromrichter zur Abführung von im Betrieb erzeugter Verlustwärme derart ausgebildet, dass eine im ersten Innenraum erzeugte erste Verlustwärme zumindest teilweise von dem gasförmigen Wärmestromkreislauf aufgenommen wird, die derart aufgenommene erste Verlustwärme zumindest teilweise mittels des Wärmetauscherkanal vom gasförmigen Wärmestromkreislauf an den gasförmigen Kühlstrom des zweiten Innenraums übergeben und mittels des gasförmigen Kühlstroms abgeleitet wird und von dem gasförmigen Kühlstrom zumindest teilweise eine im zweiten Innenraum erzeugte zweite Verlustwärme aufgenommen und mittels des gasförmigen Kühlstroms abgeleitet wird.

Neben der im ersten Innenraum erzeugten Verlustwärme, welche mittels des gasförmigen Wärmestromkreislaufs in den Wärmetauscherkanal geleitet und dort zumindest teilweise an den gasförmigen Kühlstrom im Kühlkanal des zweiten Innenraums abgegeben wird, kann der gasförmige Kühlstrom in vorteilhafter Weise eine zweite Verlustwärme aufnehmen. Diese zweite Verlustwärme wird im zweiten Innenraum erzeugt oder zumindest in den zweiten Innenraum eingeleitet.

Sowohl die vom gasförmigen Kühlstrom über den Wärmetauscherkanal aufgenommene erste Verlustwärme, wie auch die vom gasförmigen Kühlstrom im zweiten Innenraum aufgenommene zweite Verlustwärme, werden durch den sich im Kühlkanal ausgebildeten gasförmigen Kühlstrom abgeleitet, was die jeweiligen Wärmequellen, welche die Verlustwärme erzeugen, vorteilhaft entwärmt.

Bei einer weiteren vorteilhaften Ausgestaltungsform des Stromrichters ist der Stromrichter derart betreibbar, dass sich der gasförmige Wärmestromkreislauf im ersten Innenraum, insbesondere im Wärmetauscherkanal, ausschließlich durch freie Konvektion ausbildet.

Der Vorteil ist, dass auf Bauteile zur Erzeugung des gasförmigen Wärmestromkreislaufs im ersten Innenraum verzichtet werden kann. Dass sich der gasförmige Wärmestromkreislauf durch die freie Konvektion ausbildet, kann z.B. dadurch unterstützt werden, dass ein räumlich fest vorgegebener, baulich klar begrenzter Kanal im ersten Innenraum den Verlauf und ggf. die Strömungsrichtung des gasförmigen Wärmestromkreislaufs mitbestimmt.

Bei einer weiteren vorteilhaften Ausgestaltungsform des Stromrichters umfasst der Stromrichter einen ersten Strömungserzeuger für den ersten Innenraum, wobei der erste Strömungserzeuger derart betreibbar ist, dass eine erste zwangsgeführte Konvektion im ersten Innenraum, insbesondere im Wärmetauscherkanal, erzeugt wird, welche den gasförmigen Wärmestromkreislauf ausbildet.

Die Erzeugung der zwangsgeführten Konvektion mittels des ersten Strömungserzeugers hat den Vorteil, dass sich der gasförmige Wärmestromkreislauf schnell und stabil ausbildet und ein größerer Durchsatz der ersten Verlustwärme durch den Wärmetauscherkanal erzielt wird, was zur verbesserten Effizienz der Entwärmung des ersten Innenraumes beiträgt.

Bei einer weiteren vorteilhaften Ausgestaltungsform des Stromrichters verfolgen die parallel verlaufenden Strömungsrichtungen eine gemeinsame Richtung oder entgegengesetzte Richtungen.

Aus thermischer Sicht ist die Wärmeübergabe im Wärmetauscherkanal mittels der zwei parallel, aber entgegengesetzt verlaufenden Strömungsrichtungen eine bevorzugte Lösung. Sollte jedoch aus Sicht von baulichen Anforderungen oder aus Sicht anderen Anforderungen heraus die parallel verlaufenden Strömungsrichtungen in die gemeinsame Richtung verlaufen müssen, kann auch hier die effiziente Wärmeübergabe im Wärmetauscherkanal erreicht werden, indem die Ausbildung des gasförmigen Wärmestromkreislauf und/oder des gasförmigen Kühlstroms beispielsweise durch Erzeugen der zwangsgeführten Konvektion unterstützt wird oder das Durchsatzvolumen des Wärmetauscherkanals vergrößert wird.

Bei einer weiteren vorteilhaften Ausgestaltungsform des Stromrichters weist der Wärmetauscherkanal mindestens zwei Strömungskanäle auf, welche voneinander beabstandet sind, *und* es bildet sich bei unmittelbar gegenüberliegenden Strömungskanälen ein Zwischenraum aus, welcher vom gasförmigen Kühlstrom durchströmbar ist.

Die Zwischenräume zwischen den einzelnen Strömungskanälen können in vorteilhafter Weise vom gasförmigen Kühlstrom durchströmt und somit jeder der einzelnen Strömungskanäle im Wesentlichen vollumfänglich vom gasförmigen Kühlstrom umströmt werden. Das erhöht im Gegensatz zu Strömungskanälen ohne Zwischenräume die wirksame Fläche am Wärmetauscherkanal, bei dem der gasförmige Kühlstrom die mit dem gasförmigen Wärmestromkreislauf mitgeführte erste Verlustwärme übernehmen kann.

Bei einer weiteren vorteilhaften Ausgestaltungsform des Stromrichters sind die Strömungskanäle lamelliert angeordnet.

Der Vorteil der lamellierten Anordnung der Strömungskanäle ist eine passgenaue Anordnung der Strömungskanäle mit auch präzise verlaufenden Zwischenräumen, was das Umströmen der Strömungskanäle durch den gasförmigen Kühlstrom weiter verbessert.

Bei einer weiteren vorteilhaften Ausgestaltungsform des Stromrichters ist der Stromrichter derart betreibbar, dass sich der gasförmige Kühlstrom, insbesondere im überlappenden Bereich des Kühlkanals mit dem Wärmetauscherkanal, ausschließlich durch freie Konvektion ausbildet.

Der Vorteil ist, dass auf Bauteile zur Erzeugung des gasförmigen Wärmestromkreislaufs im zweiten Innenraum verzichtet werden kann. Dass sich der gasförmige Kühlstrom durch die freie Konvektion ausbildet, kann z.B. dadurch unterstützt werden, dass ein räumlich fest vorgegebener, baulich klar begrenzter Kanal als Kühlkanal im zweiten Innenraum den Verlauf und ggf. die Strömungsrichtung des gasförmigen Kühlstroms mitbestimmt.

Bei einer weiteren vorteilhaften Ausgestaltungsform des Stromrichters umfasst der Stromrichter einen zweiten Strömungserzeuger für den zweiten Innenraum, wobei der zweite Strömungserzeuger derart betreibbar ist, dass eine zweite zwangsgeführte Konvektion im zweiten Innenraum, insbesondere im überlappenden Bereich des Kühlkanals mit dem Wärmetauscherkanal, erzeugt wird, welche den gasförmige Kühlstrom ausbildet.

Die Erzeugung der zwangsgeführten Konvektion mittels des zweiten Strömungserzeugers hat den Vorteil, dass sich der gasförmige Kühlstrom schnell und stabil ausbildet und im Kühlkanal ein größerer Durchsatz der im Wärmetauscherkanal vom gasförmigen Wärmestromkreislauf übernommenen ersten Verlustwärme und der zweiten Verlustwärme des zweiten Innenraums durch den gasförmigen Kühlstrom erzielt wird, was zur verbesserten Effizienz der Entwärmung des ersten und des zweiten Innenraumes beiträgt.

Bei einer weiteren vorteilhaften Ausgestaltungsform des Stromrichters weist der Stromrichter eine zweite Einlassöffnung und/oder eine zweite Auslassöffnung am zweiten Innenraum auf, wobei der gasförmige Kühlstrom über die zweite Einlassöffnung in den Kühlkanal hineinführbar und/oder über die zweite Auslassöffnung aus dem Kühlkanal herausführbar ist.

Mittels der Einlassöffnung kann der für die Kühlung vorgesehene Kühlstrom in den Kühlkanal des zweiten Innenraums hineingeführt werden. Ist nur die Einlassöffnung vorgesehen, ist der Austritt des dann die Verlustwärme abführenden Kühlstroms auch durch die Einlassöffnung möglich, wobei dies ggf. durch einen Druckausgleich des einströmenden gegenüber dem ausströmenden gasförmigen Kühlstrom erfolgt.

Eine bevorzugte Lösung bildet das Vorhalten von der Einlassöffnung und der Auslassöffnung. Hier sind zwei Wegpunkte des Kühlkanals definiert, welche für den Kühlkanal beispielsweise dessen Anfang an der Einlassöffnung und dessen Ende an der Auslassöffnung jeweils bestimmt.

Bei einer weiteren vorteilhaften Ausgestaltungsform des Stromrichters umfasst der Stromrichter eine erste Stromrichtekomponente, welche zumindest teilweise im ersten Innenraum angeordnet ist und im Betrieb des Stromrichters die erste Verlustwärme erzeugt oder ableitet.

Die erste Stromrichterkomponente im ersten Innenraum kann beispielsweise eine Steuerungs- oder Regelungsbaugruppe des Stromrichters mit Prozessoren sowie ggf. auch weiteren elektronischen Bauelementen sein, welche im ersten Innenraum besonders vor zerstörerischen Umwelteinflüssen, wie insbesondere vor Staub und Flüssigkeiten, vorteilhaft geschützt werden.

Bei einer weiteren vorteilhaften Ausgestaltungsform des Stromrichters umfasst der Stromrichter eine zweite Stromrichterkomponente, welche zumindest teilweise im zweiten Innenraum angeordnet ist und im Betrieb des Stromrichters die zweite Verlustwärme erzeugt oder ableitet.

Die zweite Stromrichterkomponente im zweiten Innenraum ist beispielsweise ein Leistungshalbleiterschalter oder ein Leistungshalbleitermodul mit Leistungshalbleiterschaltern, welche meist Kühlkörper zur unmittelbaren Entwärmung der Leistungshalbleiterschalter aufweisen.

Auch kann z.B. der Leistungshalbleiterschalter als Einzelbauteil oder als Bestandteil eines Leistungshalbleitermoduls im ersten Innenraum (dann als erste Stromrichterkomponente) angeordnet sein und der den Leistungshalbleiterschalter oder das Leistungshalbleitermodul unmittelbar entwärmende Kühlkörper im zweiten Innenraum (dann als zweite Stromrichterkomponente) angeordnet sein. Auch weitere elektrische Bauteile wie z.B. elektrische Filter oder Stromschienen können jeweils als zweite Stromrichterkomponente im zweiten Innenraum angeordnet sein.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Figuren näher erläutert werden. Es zeigt:
- FIG 1: eine schematische Darstellung eines erfindungsgemäßen Stromrichters mit einem Wärmetauscherkanal,
- FIG 2: eine schematische Darstellung des Wärmetauscherkanals des erfindungsgemäßen Stromrichters nach FIG 1 in einer räumlichen Darstellungsform und
- FIG 3: eine schematische Darstellung eines weiteren Wärmetauscherkanals für den erfindungsgemäßen Stromrichter in einer räumlichen Darstellungsform.

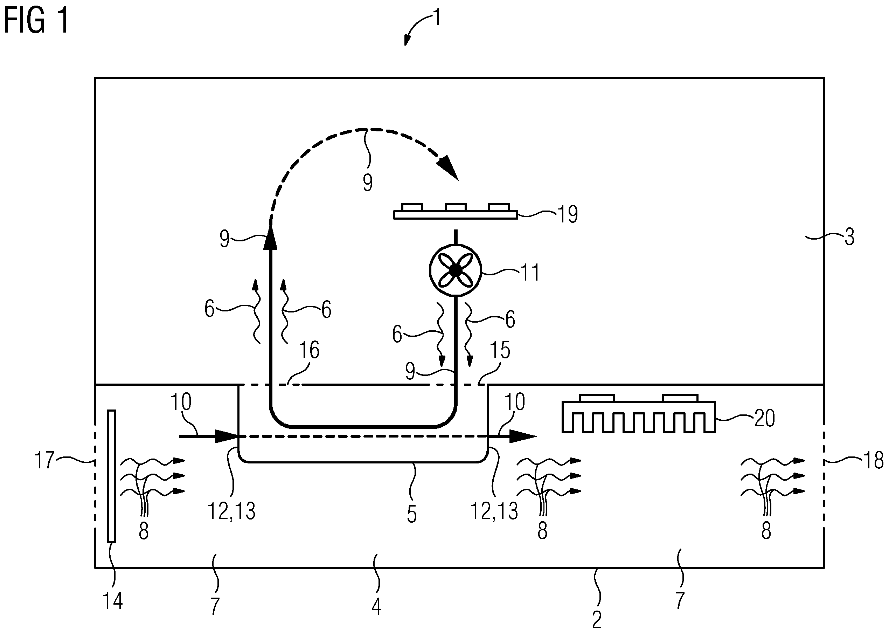

Die FIG 1 zeigt eine schematische Darstellung eines erfindungsgemäßen Stromrichters 1 mit einem Wärmetauscherkanal 5.

Der Stromrichter 1 weist ein Stromrichtergehäuse 2 mit einem ersten Innenraum 3 und einem zweiten Innenraum 4 auf. Der erste Innenraum 3 ist separat zum zweiten Innenraum 4 angeordnet. Der erste Innenraum 3 kann hermetisch gegenüber seiner gesamten Umgebung abgeschlossen sein und somit einen hermetisch abgeschlossenen Raum ausbilden.

Ein Teil des ersten Innenraumes 3 ragt dabei in den zweiten Innenraum 4 hinein und bildet den Wärmetauscherkanal 5 aus. Der Stromrichter 1 ist derart betreibbar, dass sich innerhalb des ersten Innenraumes 3 ein gasförmiger Wärmestromkreislauf 6 ausbildet. Die Ausbildung des gasförmigen Wärmestromkreislaufs 6 in eine erste Strömungsrichtung 9 wird hier durch einen ersten Strömungserzeuger 11, z.B. einen elektrischen Lüfter, unterstützt.

Der gasförmige Wärmestromkreislauf 6 nimmt von einer ersten Stromrichterkomponente 19, wie z.B. einer Steuer- oder Reglungsbaugruppe mit Prozessor und weiteren elektronischen Bauelementen, im Betrieb eine erste Verlustwärme auf. Mittels der hier durch den ersten Strömungserzeuger 11 erzeugten zwangsgeführten Konvektion wird der gasförmiger Wärmestromkreislauf 6 durch die erste Einlassöffnung 15 in den Wärmetauscherkanal 5 eingeführt. Während der gasförmige Wärmestromkreislauf 6 den Wärmetauscherkanal 5 durchströmt, wird der Wärmetauscherkanal 5 in einem Kühlkanal 7 des zweiten Innenraum 4 von einem gasförmigen Kühlstrom 8 in einer zweiten Strömungsrichtung 10 umströmt.

Der gasförmige Kühlstrom 8 nimmt die vom gasförmigen Wärmestromkreislauf 6 mitgeführte erste Verlustwärme am Wärmetauscherkanal 5 - im Bereich der Überlappung des gasförmigen Wärmestromkreislaufs 6 mit dem gasförmigen Kühlstrom 8 - zumindest teilweise auf und führt diese erste Verlustwärme von dem Wärmetauscherkanal 5 ab.

Die Ausbildung des gasförmigen Kühlstroms 8 wird in FIG 1 im Betrieb durch einen zweiten Strömungserzeuger 14 unterstützt, der hier beispielhaft im zweiten Innenraum 4 des Stromrichters 1 angeordnet ist, wobei der zweite Strömungserzeuger 14 die zweite Strömungsrichtung 10 des gasförmigen Kühlstroms 8 vorgibt. Der gasförmige Kühlstrom 8 strömt mit der zweiten Strömungsrichtung 10 durch den Kühlkanal 7 des zweiten Innenraumes 4, wobei der in den zweiten Innenraum 4 hineinragende Wärmetauscherkanal 5 in dem Kühlkanal 7 angeordnet ist.

Der gasförmige Wärmestromkreislauf 8 tritt an der ersten Auslassöffnung 16 des Wärmetauscherkanals 5 aus, wobei er einen Großteil der ersten Verlustwärme der ersten Stromrichterkomponente 19 an den gasförmigen Kühlstrom 8 abgegeben hat und der gasförmige Kühlstrom 8 die erste Verlustwärme von dem Wärmetauscherkanal 5 ableitet. Der gasförmige Kühlstrom 8 kann im Betrieb von einer zweiten Stromrichterkomponente 20 eine zweite Verlustwärme aufnehmen und diese von der zweiten Stromrichterkomponente 20 ableiten.

Die zweite Stromrichterkomponente 20 ist beispielhaft ein Leistungshalbleitermodul mit Leistungshalbleiterschaltern und einem Kühlkörper. In FIG 1 ist die zweite Stromrichterkomponente 20 innerhalb des zweiten Innenraumes 4 angeordnet. Jedoch kann auch nur ein Teil der zweiten Stromrichterkomponente 20 im zweiten Innenraum 4 angeordnet sein, so z.B. der Kühlkörper des Leistungshalbleitermoduls. Die mit dem Kühlkörper verbundenen Leistungshalbleiterschalter können dann teilweise oder vollständig im ersten Innenraum 3 angeordnet sein und dann auch teilweise durch den gasförmiger Wärmestromkreislauf 6 im ersten Innenraum entwärmt werden.

Die Ausbildung des gasförmigen Kühlstroms 8 und dessen thermische Effizienz wird dahingehend weiter verbessert, indem eine zweite Einlassöffnung 17 am zweiten Innenraum 4, in FIG 1 ist dies auch eine Einlassöffnung am Stromrichtergehäuse 2, den gasförmigen Kühlstrom 8, vor Übernahme der ersten und/oder der zweiten Verlustwärme, von außerhalb in den zweiten Innenraum einleiten lässt. Nach Aufnahme der ersten und/oder der zweiten Verlustwärme aus dem zweiten Innenraum 4 durch den gasförmigen Kühlstrom 8 wird über eine zweite Auslassöffnung 18 am zweiten Innenraum 4, in FIG 1 ist dies auch eine Auslassöffnung am Stromrichtergehäuse 2, der gasförmige Kühlstrom 8, zur Ableitung der ersten und/oder der zweiten Verlustwärme, nach außerhalb des zweiten Innenraumes 4 abgeleitet.

Der Wärmetauscherkanal 5 weist Strömungskanäle 12 auf, in denen sich der gasförmige Wärmestromkreislauf 6 in der ersten Strömungsrichtung 9 ausbildet, wobei in der Darstellungsart der FIG 1 nur ein Strömungskanal 12 darstellbar ist.

Zwei voneinander beabstandete und sich unmittelbar gegenüberliegende Strömungskanäle 12 bilden jeweils einen Zwischenraum 13 aus, welcher von dem gasförmigen Kühlstrom 8 durchströmt wird (ist in FIG 1 nur andeutungsweise aufgrund der Darstellungsart darstellbar).

Der Kühlkanal 7 ist in dem überlappenden Bereich mit dem Wärmetauscherkanal 5 in FIG 1 derart angeordnet, dass die erste Strömungsrichtung 9 des gasförmigen Wärmestromkreislaufs 6 in Bezug zur zweiten Strömungsrichtung 10 des gasförmigen Kühlstroms 8 parallel verläuft und die parallel verlaufenden Strömungsrichtungen 9,10 entgegengesetzte Richtungen verfolgen.

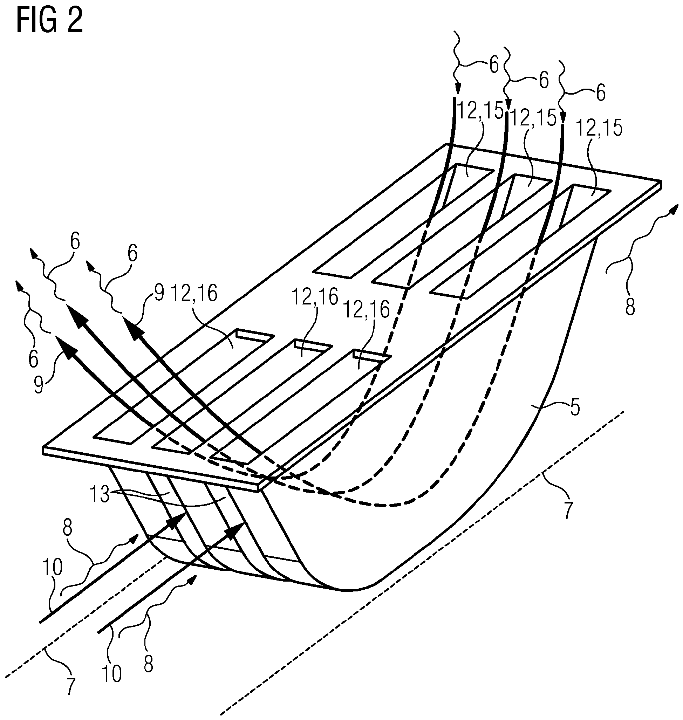

In FIG 2 wird eine schematische Darstellung des Wärmetauscherkanals 5 des erfindungsgemäßen Stromrichters nach FIG 1 in einer räumlichen Darstellungsform aufgezeigt.

Der Wärmetauscherkanal 5 in FIG 2 weist drei Strömungskanäle 12 auf. Über die erste Einlassöffnung 15 des Wärmetauschkanals 5 strömt im Betrieb der gasförmige Wärmestromkreislauf 6 mit der ersten Verlustwärme des ersten Innenraumes in erster Strömungsrichtung 9 in die Strömungskanäle 12. Die voneinander beabstandeten und sich unmittelbar gegenüberliegenden Strömungskanäle 12 bilden hier zwei Zwischenräume 13 aus, durch welche der gasförmige Kühlstrom 8 in zweiter Strömungsrichtung 10 strömt, die erste Verlustwärme von dem gasförmigen Wärmestromkreislauf 6 zumindest teilweise übernimmt und diese über den Kühlkanal 7 von dem Wärmetauscherkanal 5 ableitet. Über die erste Auslassöffnung 16 strömt der gasförmige Wärmestromkreislauf 6 nach zumindest teilweiser Abgabe der ersten Verlustwärme in erster Strömungsrichtung 9 aus dem Wärmetauscherkanal 5 aus.

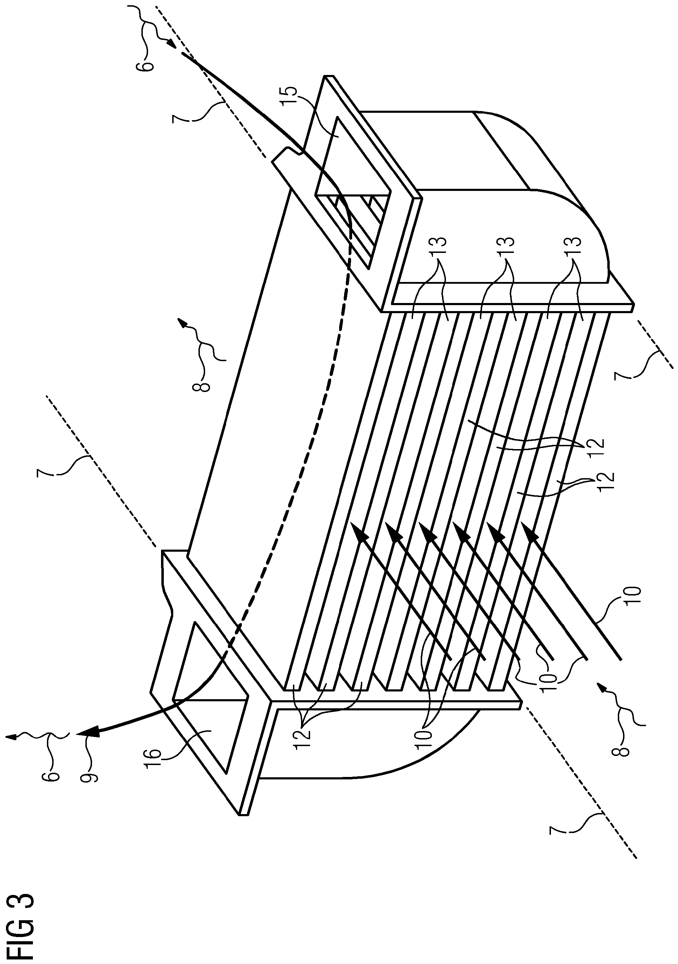

Mit FIG 3 wird eine schematische Darstellung eines weiteren Wärmetauscherkanals 5 für den erfindungsgemäßen Stromrichter in einer räumlichen Darstellungsform gezeigt.

Der Wärmetauscherkanal 5 in FIG 3 weist sieben Strömungskanäle 12 auf. Über eine erste Einlassöffnung 15 des Wärmetauschkanals 5 strömt im Betrieb ein gasförmiger Wärmestromkreislauf 6 mit einer ersten Verlustwärme eines ersten Innenraumes in einer ersten Strömungsrichtung 9 in die Strömungskanäle 12. Die voneinander beabstandeten und sich unmittelbar gegenüberliegenden Strömungskanäle 12 bilden hier sechs Zwischenräume 13 aus, durch welche ein gasförmiger Kühlstrom 8 in zweiter Strömungsrichtung 10 strömt, die erste Verlustwärme von dem gasförmigen Wärmestromkreislauf 6 zumindest teilweise übernimmt und diese über einen Kühlkanal 7 von dem Wärmetauscherkanal 5 ableitet. Über eine erste Auslassöffnung 16 strömt der gasförmige Wärmestromkreislauf 6 nach zumindest teilweiser Abgabe der ersten Verlustwärme in erster Strömungsrichtung 9 aus dem Wärmetauscherkanal 5 aus.

Im Gegensatz zu dem in FIG 1 und FIG 2 dargestellten Wärmetauscher ist der Kühlkanal 7 in FIG 3 in einem überlappenden Bereich mit dem Wärmetauscherkanal 5 derart angeordnet, dass die erste Strömungsrichtung 9 des gasförmigen Wärmestromkreislaufs 6 in Bezug zur zweiten Strömungsrichtung 10 des gasförmigen Kühlstroms 8 senkrecht verläuft.

## Patentansprüche

1. Stromrichter (1), umfassend ein Stromrichtergehäuse (2) mit einem ersten Innenraum (3) und einem zweiten Innenraum (4), wobei
- der erste Innenraum (3) zum zweiten Innenraum (4) separat angeordnet ist,
- ein Teil des ersten Innenraumes (3) in den zweiten Innenraum (4) ragt und einen Wärmetauscherkanal (5) bildet,
- der Stromrichter (1) derart betreibbar ist, dass sich innerhalb des ersten Innenraumes (3) ein gasförmiger Wärmestromkreislauf (6) ausbildet, welcher durch eine erste Einlassöffnung (15) des Wärmetauscherkanals (5) einströmt und durch eine erste Auslassöffnung (16) des Wärmetauscherkanals (5) ausströmt,
- der zweite Innenraum (4) einen Kühlkanal (7) bildet,
- der Stromrichter (1) derart betreibbar ist, dass sich ein durch den Kühlkanal (7) strömender gasförmiger Kühlstrom (8) ausbildet, welcher den Wärmetauscherkanal (5) umströmt, und
- der Kühlkanal (7) in einem überlappenden Bereich mit dem Wärmetauscherkanal (5) derart angeordnet ist, dass eine erste Strömungsrichtung (9) des gasförmigen Wärmestromkreislaufs (6) in Bezug zu einer zweiten Strömungsrichtung (10) des gasförmigen Kühlstroms (8) im Wesentlichen senkrecht oder parallel verläuft.

2. Stromrichter (1) nach Anspruch 1, wobei der erste Innenraum (3) zumindest im Betrieb des Stromrichters (1) einen im Wesentlichen hermetisch abgeschlossen Raum bildet.

3. Stromrichter (1) nach einem der Ansprüche 1 oder 2, wobei der Stromrichter (1) zur Abführung von im Betrieb erzeugter Verlustwärme derart ausgebildet ist, dass
- eine im ersten Innenraum (3) erzeugte erste Verlustwärme zumindest teilweise von dem gasförmigen Wärmestromkreislauf (6) aufgenommen wird,
- die derart aufgenommene erste Verlustwärme zumindest teilweise mittels des Wärmetauscherkanal (5) vom gasförmigen Wärmestromkreislauf (6) an den gasförmigen Kühlstrom (8) des zweiten Innenraums (4) übergeben und mittels des gasförmigen Kühlstroms (8) abgeleitet wird und
- von dem gasförmigen Kühlstrom (8) zumindest teilweise eine im zweiten Innenraum (4) erzeugte zweite Verlustwärme aufgenommen und mittels des gasförmigen Kühlstroms (8) abgeleitet wird.

4. Stromrichter (1) nach einem der Ansprüche 1 bis 3, wobei der Stromrichter (1) derart betreibbar ist, dass sich der gasförmige Wärmestromkreislauf (6) im ersten Innenraum (3), insbesondere im Wärmetauscherkanal (5), ausschließlich durch freie Konvektion ausbildet.

5. Stromrichter (1) nach einem der Ansprüche 1 bis 3, umfassend einen ersten Strömungserzeuger (11) für den ersten Innenraum (3), wobei der erste Strömungserzeuger (11) derart betreibbar ist, dass eine erste zwangsgeführte Konvektion im ersten Innenraum (3), insbesondere im Wärmetauscherkanal (5), erzeugt wird, welche den gasförmigen Wärmestromkreislauf (6) ausbildet.

6. Stromrichter (1) nach einem der vorhergehenden Ansprüche, wobei die parallel verlaufenden Strömungsrichtungen (9,10) eine gemeinsame Richtung oder entgegengesetzte Richtungen verfolgen.

7. Stromrichter (1) nach einem der vorhergehenden Ansprüche, wobei der Wärmetauscherkanal (5) mindestens zwei Strömungskanäle (12) aufweist, welche voneinander beabstandet sind, und wobei sich bei unmittelbar gegenüberliegenden Strömungskanälen (12) ein Zwischenraum (13) ausbildet, welcher vom gasförmigen Kühlstrom (8) durchströmbar ist.

8. Stromrichter (1) nach Anspruch 7, wobei die Strömungskanäle (12) lamelliert angeordnet sind.

9. Stromrichter (1) nach einem der vorhergehenden Ansprüche, wobei der Stromrichter (1) derart betreibbar ist, dass sich der gasförmige Kühlstrom (8), insbesondere im überlappenden Bereich des Kühlkanals (7) mit dem Wärmetauscherkanal (5), ausschließlich durch freie Konvektion ausbildet.

10. Stromrichter (1) nach einem der Ansprüche 1 bis 8, umfassend einen zweiten Strömungserzeuger (14) für den zweiten Innenraum (4), wobei der zweite Strömungserzeuger (14) derart betreibbar ist, dass eine zweite zwangsgeführte Konvektion im zweiten Innenraum (4), insbesondere im überlappenden Bereich des Kühlkanals (7) mit dem Wärmetauscherkanal (5), erzeugt wird, welche den gasförmigen Kühlstrom (8) ausbildet.

11. Stromrichter (1) nach einem der vorhergehenden Ansprüche, aufweisend eine zweite Einlassöffnung (17) und/oder eine zweite Auslassöffnung (18) am zweiten Innenraum (4), wobei der gasförmige Kühlstrom (8) über die zweite Einlassöffnung (17) in den Kühlkanal (7) hineinführbar und/oder über die zweite Auslassöffnung (18) aus dem Kühlkanal (7) herausführbar ist.

12. Stromrichter (1) nach einem der vorhergehenden Ansprüche, umfassend eine erste Stromrichterkomponente (19), welche zumindest teilweise im ersten Innenraum (3) angeordnet ist und im Betrieb des Stromrichters (1) die erste Verlustwärme erzeugt oder ableitet.

13. Stromrichter (1) nach einem der vorhergehenden Ansprüche, umfassend eine zweite Stromrichterkomponente (20), welche zumindest teilweise im zweiten Innenraum (4) angeordnet ist und im Betrieb des Stromrichters (1) die zweite Verlustwärme erzeugt oder ableitet.
